(19) Europäisches Patentamt
European Patent Office
Office européen des brevets

(11) **EP 2 761 661 B1**

(12) **EUROPEAN PATENT SPECIFICATION**

(45) Date of publication and mention
of the grant of the patent:
**28.04.2021 Bulletin 2021/17**

(51) Int Cl.:
***H01L 29/745*** (2006.01)   ***H01L 21/332*** (2006.01)

(21) Application number: **12837357.8**

(22) Date of filing: **01.10.2012**

(86) International application number:
**PCT/US2012/058361**

(87) International publication number:
**WO 2013/049850 (04.04.2013 Gazette 2013/14)**

(54) **MCT DEVICE WITH BASE-WIDTH-DETERMINED LATCHING AND NON-LATCHING STATES**

MCT-VORRICHTUNG MIT BASISBREITENBESTIMMTEN VERRIEGELUNGS-UND NICHTVERRIEGELUNGSZUSTÄNDEN

DISPOSITIF MCT À ÉTATS DE VERROUILLAGE ET DE NON-VERROUILLAGE DÉTERMINÉS PAR LARGEUR DE BASE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.09.2011 US 201161540819 P**

(43) Date of publication of application:
**06.08.2014 Bulletin 2014/32**

(73) Proprietor: **Pakal Technologies, Inc.**
**San Francisco, CA 94111 (US)**

(72) Inventors:
• **BLANCHARD, Richard, A.**
**Los Altos, CA 94024 (US)**
• **AKIYAMA, Hidenori**
**Sendai-shi, Miyagi 981-3202 (JP)**
• **TWORZYDLO, Woytek**
**Austin, TX 78728 (US)**

(74) Representative: **Müller-Boré & Partner**
**Patentanwälte PartG mbB**
**Friedenheimer Brücke 21**
**80639 München (DE)**

(56) References cited:
EP-A1- 0 854 518     EP-A2- 0 480 356
GB-A- 2 305 777      JP-A- H05 243 561
US-A- 5 369 291      US-A- 6 091 107
US-A1- 2005 045 960  US-A1- 2007 235 752
US-A1- 2009 020 852  US-A1- 2010 193 835

## Description

## BACKGROUND

The present application relates to gate-controlled thyristor devices which achieve a conductive latchup state which can be turned off by a small gate signal.

A thyristor is a four-layer solid-state structure which has long been an attractive candidate for high-current switches. Thyristors combine very high current ratings with very high voltage-withstand capabilities, which makes this class of devices the leading candidate for very high voltage switches and for handling very high power. For example, as of 2012, off-the-shelf packaged thyristors can withstand more than 10,000 Volts, and can switch more than 10 Megawatts of power in each unit. However, the basic thyristor structure cannot be turned off by just returning the "turn-on" terminal to 0 Volts, or even to a small negative voltage. Once it is turned on, it stays on for as long as it can draw a minimum holding current.

The basic thyristor structure can be thought of as a merged structure which combines a PNP bipolar transistor with an NPN bipolar transistor. Each of these bipolar transistors provides the base current of the other, so there is potentially a positive feedback relationship: the collector current in the NPN is the base current of the PNP, and the collector current of the PNP is the base current of the NPN. The gain of a bipolar transistor is normally stated as "beta" ($\beta$), which is the ratio of collector current to base current. In a thyristor, there will be positive feedback if the product of the two betas is greater than one ($\beta_{NPN} \cdot \beta_{PNP} > 1$). If this positive feedback relation is present, then, whenever the thyristor is turned ON, it will draw current up to the maximum the external terminals can supply, or until the bipolar devices reach saturation.

When this basic thyristor is OFF, the junction between the n-base and p-base regions will be reverse biased, and this condition blocks conduction. (The anode will be connected to a voltage which is more positive than the cathode voltage.) A depletion region, with a width depending on the applied voltage, will be present on both sides of this pn-junction formed by the base of the NPN transistor and the base of the PNP transistor. The two other junctions will be forward biased, but no current flows (other than leakage), since the reverse biased junction is present.

When the thyristor is ON, conduction is as follows. (Note that current is carried by both electrons and holes flowing in opposite directions, but current in the conventional sense only flows in one direction.) Holes will pass from the p+ anode region through the n-base region into the p-base region, and thence into the n+ cathode (where they will typically recombine with the majority carriers, which in the n+ region are electrons). Since the holes have positive charge, their movement means that current (in the conventional sense) flows from the anode to the cathode. Similarly, electrons will pass from the n+ cathode region through the p-base region into the n-base region, and thence into the p+ anode (where they will typically recombine with the majority carriers, which in this region are holes). Since the electrons have negative charge, their movement means that current (in the conventional sense) is opposite to the physical movement of the electrons, i.e. current flows from the anode to the cathode. Since current is carried by both electrons and holes, this thyristor is a bipolar (or "minority carrier") device, and operates quite differently than unipolar (or "majority carrier") devices, such as field-effect transistors, where current flows because of the motion of only one carrier type.

When a thyristor has been turned ON, it is electrically analogous to a simple junction diode, but with a lower forward voltage drop than a junction diode.

Issued patent US 7,705,368 B2 to Rodov and Akiyama, which is commonly owned with the present application, described a fundamentally new structure for a MOS-controlled thyristor ("MCT"). The present application provides improvements on the structures and methods disclosed in that patent.

Turn-on in an MCT is relatively simple, but turn-off is the more difficult challenge in this technology. The Rodov et al. patent describes (among other teachings) a MOS-controlled thyristor in which a mesa of n-type semiconductor between the cathode contact and the n-emitter/p-base junction can be depleted by a sufficiently negative gate voltage (applied to a trench gate). The gate trench extends down through the n+ emitter layer, and into, but not through, the p-base layer. The voltage on the gate electrode can cause depletion of the p-type material in these mesas, which "pinches off" the connection to the cathode terminal, and thereby interrupts conduction. However, a mesa width of less than the Debye length is required for the gate to turn the Rodov et al. device OFF. This gate-to-gate distance is typically 1 micron or less in such a thyristor device. For a discrete power device, this is very small and will result in a high manufacturing cost. The Rodov et al. device benefits from trench gate oxide thicknesses as small as 10 nm or so, but this further increases manufacturing costs and lowers the yield.

The thyristor devices of Rodov et al. have great advantages over IGBTs, but the Rodov et al. devices usually require that the gate voltage be pulsed positive to turn the device ON and negative to turn the device OFF. A power circuit used to control this type of thyristor device would therefore be quite different from the power circuit used to drive most IGBTs, in which the gate voltage is held constant while in the ON state, and returned to zero volts to turn the IGBT off.

EP 0 480 356 A2 describes a trenched gate thyristor where a vertical channel must be created between two N-type regions in order for conduction to be made across a depletion region to turn the thyristor on. Such a device is difficult to fabricate, and achieving a consistent threshold voltage is also difficult.

EP 0 854 518 A1 describes a gate-controlled thyristor where a lateral channel must first be created in order to turn the device on.

## SUMMARY

The present application discloses new approaches to gate-controlled thyristors. There are some apparent structural similarities to Rodov - e.g., a trench gate is still used - but with important differences in structure and operation. With no gate voltage applied, the product of the gain of the NPN times the gain of the PNP is preferably less than unity. This means that even if the device is somehow triggered into conduction, it will not latch. However, if the trench gate is turned on (driven sufficiently positive), an inversion layer forms at the trench sidewalls and bottom. In this inversion layer, electrons are the majority carriers, so the population of electrons at the bottom of the trench provides a "virtual emitter" for the NPN bipolar transistor. The behavior of the NPN is now determined by this virtual (induced) emitter, not by the n+ diffusion at the top surface. In effect, the NPN device has been changed from a wide-base bipolar transistor, with correspondingly low gain, to a bipolar NPN with a much narrower base. As with any bipolar transistor, a reduction in base width, while other device parameters remain unchanged, greatly increases the gain (beta) of this transistor. Thus the gate can change the NPN from being a wide-base transistor to being a narrow-base transistor.

The disclosed innovations, in various embodiments, provide one or more of at least the following advantages.

- Low ON voltage;
- High performance;
- Decreased manufacturing cost;
- Can be controlled by the same drive circuit as would be used for an IGBT; and
- Allows use of wider trench distances and thicker trench gate oxides than the most preferred teachings of Rodov.

## BRIEF DESCRIPTION OF THE DRAWINGS

The disclosed invention, as defined by the appended claims, will be described with reference to the accompanying drawings, wherein:

**Figure 1** schematically shows a cross section of an IGTO embodiment of the present invention.
**Figure 1A** shows a known IGTO device, and **Figure IB** shows its equivalent circuit.
**Figure 2** shows an equivalent circuit of the device of Figure 1.
**Figure 3A** shows an equivalent circuit of the present IGTO biased OFF.
**Figure 3B** shows an equivalent circuit of the present IGTO biased ON.
**Figures 4A-4B** show a top view of a closed gate structure and the corresponding p-type and N+ type diffused regions.
**Figures 5A-5C** show top views of open gate structures and the corresponding p-type and N+ type diffused regions.
**Figure 6** shows an example of making contact to the gate of the present IGTO.

## DETAILED DESCRIPTION OF SAMPLE EMBODIMENTS

In general, a thyristor can be thought of as the combination of a reverse-biased junction (the base-base junction), which provides all the voltage withstand in the OFF state, with two base-emitter junctions on opposite sides of the base-base junction. (These two additional junctions are electrically in series with the base-base junction.) In the ON state, the combination of the two emitter-base junctions provides net round-trip carrier multiplication, so the device latches when it is turned on.

Rodov et al. patent US 7,705,368 B2 describes a gated thyristor device where the connection to one of the emitters is pinched off to interrupt conduction. The Rodov et al. patent apparently does not say that the combination of the two metallurgical emitter-base junctions will not latch if such pinch-off is not present. The present application specifically teaches that thicknesses and dopings should be selected so that the combination of the two metallurgical emitter-base junctions will not latch by themselves.

Thus the preferred implementations disclosed in the present application differ from the preferred implementations of Rodov et al. both in structure and in function. The structure is different, in that the two metallurgical emitter-base junctions do not provide net round-trip carrier multiplication by themselves (i.e. not unless a portion of the upper base has been inverted). That translates into different thicknesses and/or dopings and/or carrier lifetimes, as discussed below. The function is surprisingly different, in that carrier multiplication between the two emitter-base junctions does not have to be disabled in the OFF state.

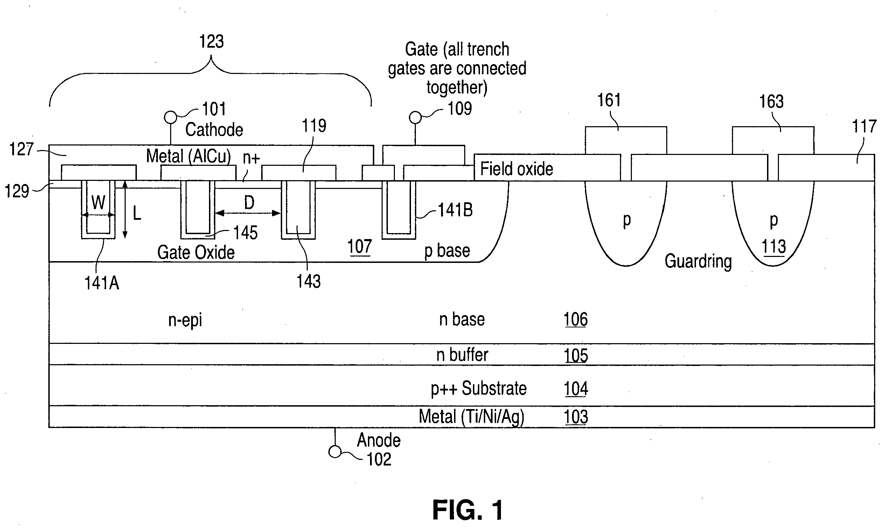

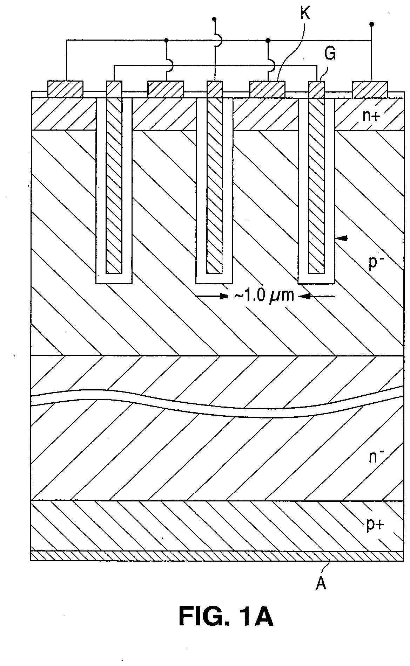

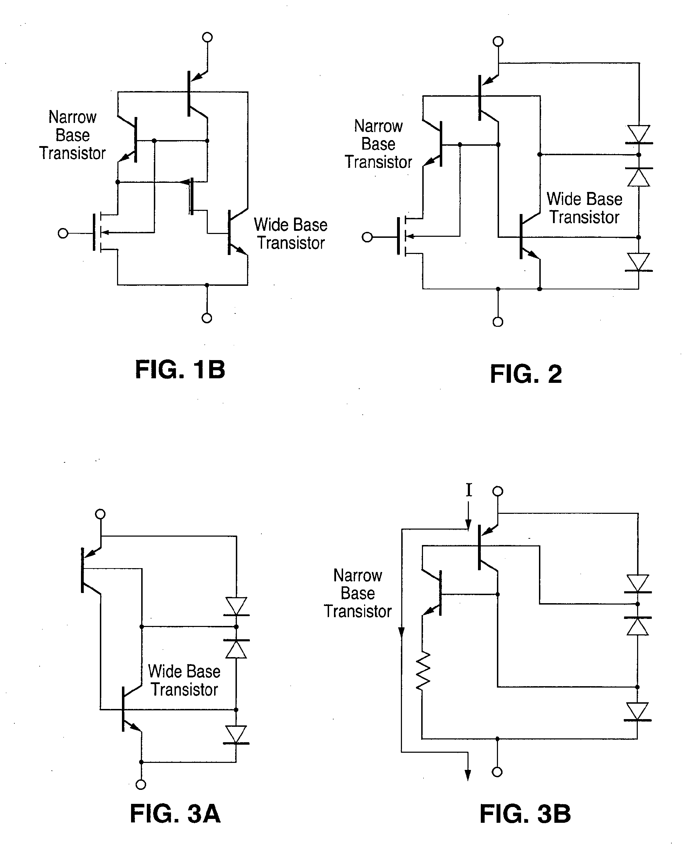

An important further difference is that the Rodov structure apparently requires that the active area be completely surrounded by the trench where the gate is contacted. This helps to assure that uncontrolled conduction does not occur if the areas of carrier multiplication have not been properly terminated. By contrast, in the device of Figure 1, this is not strictly necessary, since conduction will not be sustained unless the device is ON.

To analyze carrier multiplication, a crucial relation is the product of the NPN and PNP current gains: if (at the relevant voltage and current)

$$\beta_{NPN}\beta_{PNP} > 1,$$

then the device will latch when triggered; but if

$$\beta_{NPN}\beta_{PNP} < 1,$$

the device will not sustain conduction, even if it has already been turned on.

The disclosed inventions, by changing the gain of the NPN transistor, allow BOTH of these states to be achieved. The relevant relations are now:

$$\beta_{NPN\text{-}wide} < 1/\beta_{PNP},$$

and

$$\beta_{NPN\text{-}narrow} > 1/\beta_{PNP}.$$

That is, the NPN beta is not only changed by shifting between wide-base and narrow-base behaviors, but the product of the betas must change between a value which is less than unity in the OFF state, and a value which is greater than unity in the ON state. There are two additional tools which can be used to assure that these two beta-products fall on different sides of unity.

In addition to the switch between wide-base and narrow-base operation, it is also possible to lower both gains by reducing carrier lifetime. This can be done by introducing deep-level dopants (such as gold or platinum), or by irradiation using electrons or other high energy particles, followed by an anneal. This carrier lifetime reduction has unexpected synergy when used in combination with switching between wide- and narrow-base operation.

In the narrow-base condition, conduction is preferably initiated merely by placing a positive voltage on the anode terminal. The positive voltage on the anode attracts electrons from the virtual emitter induced at the trench bottom (i.e. the population of electrons in the inversion layer induced in the p-base layer at the bottom of the gate trench). Electrons will flow through the portion of the p-base below the trench, to initiate the positive-feedback relation which turns the device fully ON.

According to an example not forming part of the present invention but useful for its understanding, in order to fabricate the innovative structure, e.g. like that shown in **Figure 1,** the starting material would be a P++ substrate, e.g. of silicon. (The disclosed example can also be applied to other semiconductor materials, and can be particularly advantageous in wider-bandgap semiconductor materials, such as Group III nitrides or silicon carbide.) The three terminals of the present device are shown as cathode terminal **101,** anode terminal **102,** and gate terminal **109.**

An n-type buffer layer **105** is grown epitaxially on the P++ starting substrate **104.** An epitaxial layer **106** is then grown on top of the N type buffer layer 105. The doping of the substrate 104 can be, for example, 0.001-0.020 Ω·cm. The doping of the N-type buffer 105 can be, for example, $10^{14}$-$10^{16}$ cm$^{-3}$. The doping of the N-type epitaxial layer 106 can be e.g. $10^{13}$-$10^{15}$ cm$^{-3}$. This dopant concentration can be obtained e.g. by in-situ doping during epi growth.

A P-type base region **107** is then implanted. Preferably the guard rings **113** are also formed in the same patterned implant. The peak doping in the P-type base region 107 can be, for example, $10^{16}$-$10^{18}$ cm$^{-3}$.

Additional field oxide **117** is then grown to a thickness of, for example, 0.6-1.5 microns. The field oxide 117 is then preferentially etched from the emitter areas **123** using a masked etch.

A masked implant is used to create the shallow N+ layer **129.** This can be very heavily doped, and can be formed, e.g., by an implant of arsenic or phosphorus at an energy of 10-100 keV and an area dose of $5\times10^{14}$-$10^{16}$ cm$^{-2}$.

In one example, the inter-level dielectric **119** is 0.6-1.2 microns thick of silicon dioxide, and the field oxide 117 is 0.6-1.5 microns thick of silicon dioxide. However, these can of course be varied.

Patterning of the inter-level dielectric 119 exposes contacts, where the metal **127** can make contact to a shallow N+ region 129. The N+ region 129 provides the emitter of the NPN transistor, and also provides ohmic contact to the cathode metallization 127. The cathode metallization 127 in this example is an aluminum-copper alloy, but can of course be made of other materials, as is well known. Barrier metallization can also be used at the contact if desired.

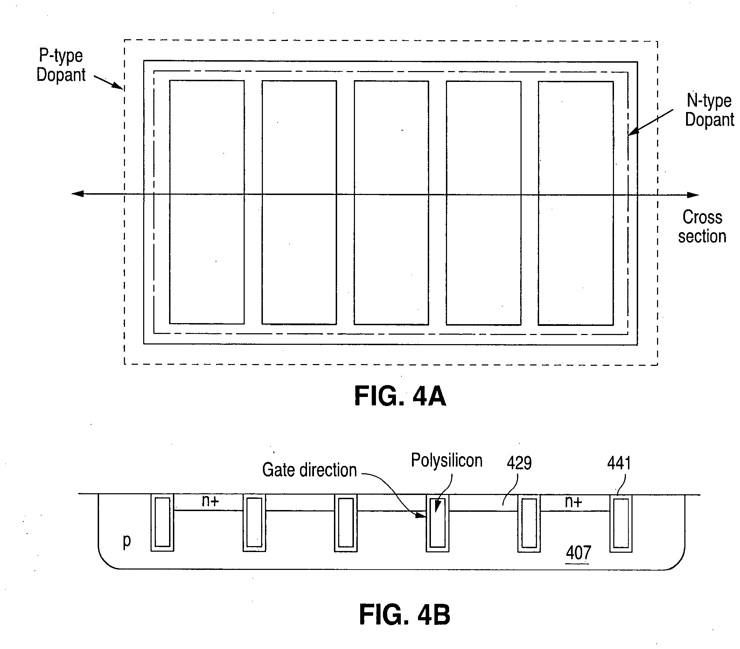

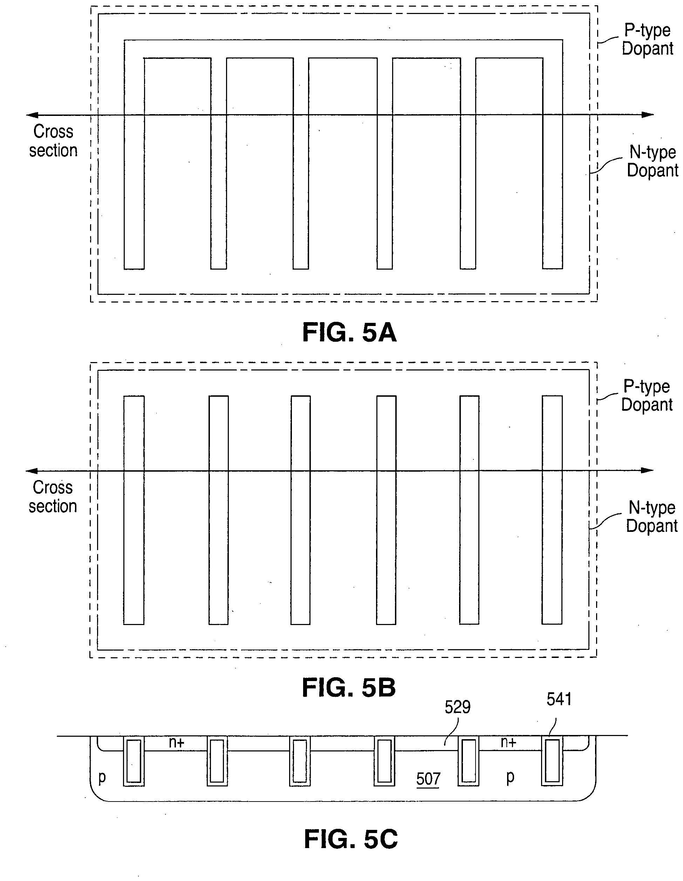

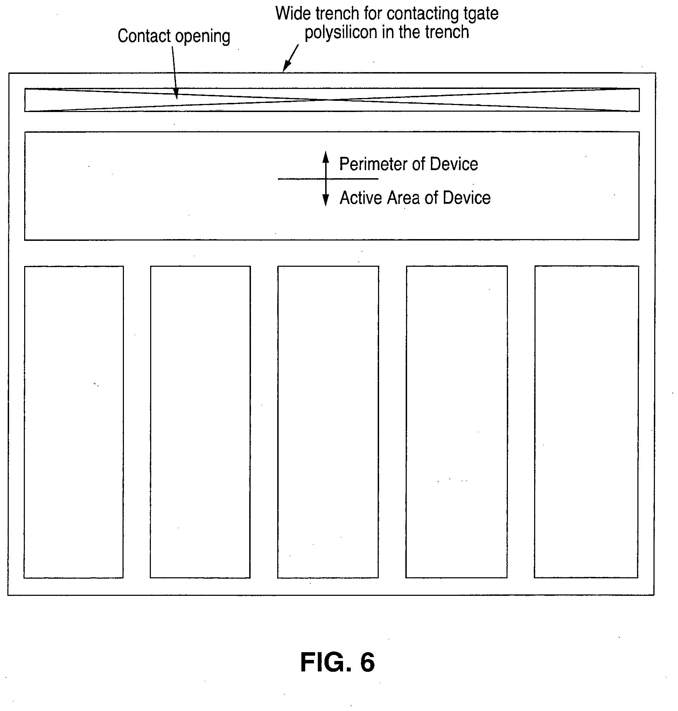

Either before or after the masked implant which forms the N+-emitter, trenches **141** are etched in the active area. Note that this trench etch preferably creates two locations as seen in the top view of **Fig. 6.** The gates which are connected to control conduction from the cathode through the adjacent part of P base 107 are preferably surrounded by a line of trenches **141B** in which contact can be made to the gate electrode. Thus the gate electrode is a buried mesh within the surface of the semiconductor material. Preferably the trench gate portions 141B either surround the active gate portions **141A,** or else totally outflank it as shown in Figures 4A-4B and 5A-5C.

The trench depths can be e.g. 2-10 microns, but the minimum lateral trench widths are constrained by lithographic and etching limitations.

After trenches **141** are etched, a gate oxide **145** is preferably grown on the sidewalls and bottoms of those gates. This gate oxide 145 is relatively thin, and can be, for example, 0.05-0.15 microns thick. A conductive material **143,** e.g. heavily doped polysilicon, then fills the trenches 141, and is, in the example shown, planarized to the surface of the semiconductor material. Alternatively, it is also possible to recess the gate electrodes slightly, or to have them protrude slightly, as long as they are insulated from the cathode metal **127.**

Note that the voltage withstand requirements of the gate oxide 145 are not very high since the gate electrodes **143A** and **143B** are close in potential to the cathode metal 127, and since the structure is preferably architected so that breakdown occurs first at the periphery.

The location of the origin of the "breakdown" of the reverse biased pn-junction is a function of a number of variables, including the geometry of the doped regions in the "termination," the junction depths in this region, and dopant profiles in this region. (This complex relationship is discussed, for instance in Chapter 3 of Power Semiconductor Devices by B. Jayant Baliga, PWS Publishing Company, 1996.)

One or more second metal regions **161** and **163** preferably make contact to concentric guard rings 113. This structure helps to assure that when breakdown happens, the fragile gate oxides in the active area will not be damaged.

The backside of the semiconductor wafer can then be coated with a contact metallization of Ti/Ni/Ag 103 to which contact is made to provide the large anode current. Typically high current voltages of this type will be packaged in a plastic power package such as a TO-220 or TO-252 package. Fabrication is completed with protective overcoat and external contact formation.

**Figure 1A** shows a prior art IGTO, and **Figure 1B** shows its equivalent circuit. Several of the dimensions noted, particularly the 10-nm thickness of gate oxide and the ~1.0-micron spacing between gates, are those noted above as increasing manufacturing cost and decreasing yield in said prior IGTO.

An equivalent circuit of the device of Figure 1 is shown in **Figure 2**. This figure is drawn conventionally, with the most positive terminal, the P++ substrate metal electrode, at the top of the schematic, and the n-type cathode at the bottom. (Note that following this convention results in an equivalent circuit that is "upside down" when compared to the cross section of Fig. 1.) The three main components shown in the equivalent circuit of this device are as follows: a PNP transistor with the P++ substrate forming its emitter, an n-type base, and the p-type region near the top surface as its collector; an NPN transistor with the N+ top layer as its emitter, a p-type base, and an n-type collector; and a trench MOSFET with the N+ top layer as its source, a p-type body, an n-type drain and its gate in the trench.

With a positive voltage on the anode, no current flows between the anode and cathode with zero volts or with a negative voltage applied between the gate and the cathode. However, when a positive voltage of, for example, +10V is applied to the gate, the device turns ON, and behaves as seen in e.g. **Figure 3B.** When the driving gate voltage drops below the minimum needed to maintain the virtual emitter for narrow-base operation, the device turns OFF, and behaves as in **Figure 3A.**

**Figure 4A** shows one example of a top view of a closed gate structure in which the trench gate structures surround the active gate portions, with **Figure 4B** showing the corresponding p-type and N+ diffused regions.

**Figures 5A** and **5B** show top views of two alternatives for open gate structures with the corresponding p-type and N+ diffused regions shown in **Figure 5C.** Note that where N+ active regions **429** end at gate trench **441** in Fig. 4B, corresponding N+ active regions **529** continue past corresponding gate trench **541** in Figure 5C.

**Figure 6** shows the location where electrical contact is made to the polysilicon in the gate trenches. By placing these gate contact regions at the outer perimeter of the active area, the metal that contacts the n+ emitter/source region can be continuous.

At the end of these fabrication steps, carrier lifetime is preferably reduced. This is preferably done by gold or platinum implant, but can alternatively be done by electron irradiation. Carrier lifetime is reduced sufficiently that the two emitter-base junctions will not latch if the trench gate is not inverting parts of the adjacent base region.

The present invention is defined by the independent claims. Preferred embodiments are defined in the dependent claims. According to one example not claimed but useful for understanding the invention, there is provided: A gate-controlled thyristor, comprising: an n-type emitter region, overlying a p-type base region, which itself overlies an n-type base region, which in turn overlies a heavily doped p-type emitter region; one or more insulated gate electrodes lying in gate trenches which extend down into, but not through, said p-type base region; wherein the NPN current gain defined by the combination of said n-type emitter with said p-type base and said n-type base, multiplied by the PNP current gain defined by the combination of said p-type emitter with said n-type base and said p-type base, is less than one; and wherein, at times when said gate electrode has been driven sufficiently positive to invert portions of said p-type base region, the NPN current gain defined by the combination of an induced population of electrons at the bottom of said trench with said p-type base and said n-type base, multiplied by the PNP current gain defined by the combination of said p-type emitter with said n-type base and said p-type base, is greater than one; whereby, when said gate electrode is sufficiently positive to invert said p-base region, current will flow from said anode to said cathode terminal under forward bias; and when said gate electrode is not sufficiently positive to invert said p-base region, current from said anode to said cathode will be interrupted.

According to another example not claimed but useful for understanding the invention, there is provided: A semiconductor device for controllable bipolar conduction at a rated voltage, comprising: an active area, including one or more first emitter regions of a first conductivity type overlying a first semiconductor base region of a second conductivity type; an upper part of said first base region being partially penetrated by one or more trenches which contain an insulated gate electrode, and which surround or partially surround mesa portions of said first base region; a base-base junction, underlying said first base region, which is separated from the bottoms of said trenches by a thickness of said first base region which is sufficient that some of said first base region below the bottoms of said trenches is not fully depleted when the device is off and is withstanding the rated voltage; a second base region of said first conductivity type, which is separated from said first base region by said base-base junction, and a second emitter region of said second conductivity type; and external connections to said first and second emitter regions, and to said gate; wherein, when said gate electrode has a potential which inverts adjacent portions of said upper part, the combination of said second emitter region, said second base region, said first base region, and an induced population of first-conductivity-type carriers near the bottom of said trenches, provides enough secondary carrier generation to remain latched into an ON state once conduction has begun; and wherein the combination of said first emitter and said first base region, together with the combination of said second emitter and said second base region, do not provide enough secondary carrier generation to remain latched into an ON state once conduction has begun, unless said induced population is present.

According to another example not claimed but useful for understanding the invention, there is provided: A gate-controlled thyristor, comprising: a heavily doped first-conductivity-type emitter region, overlying a second-conductivity-type base region, which itself overlies a first-conductivity-type base region, which in turn overlies a heavily doped second-conductivity-type emitter region; one or more insulated gate electrodes lying in gate trenches which extend down through more than 10%, but less than 90%, of the depth of said p-type base region; and wherein, at times when said gate electrode has been driven sufficiently positive to invert portions of said p-type base region, the NPN current gain defined by the combination of an induced population of electrons at the bottom of said trench with said p-type base and said n-type base, multiplied by the PNP current gain defined by the combination of said p-type emitter with said n-type base and said p-type base, is greater than one; whereby, when said gate electrode is sufficiently positive to invert said p-base region, current will flow from said anode to said cathode terminal if forward bias is present; and when said gate electrode is not sufficiently positive to invert said p-base region, current from said anode to said cathode will stop.

According to another example not claimed but useful for understanding the invention, there is provided: A gate-controlled thyristor, comprising: a heavily-doped n-type emitter region, overlying a p-type base region, which itself overlies an n-type base region, which in turn overlies a heavily doped p-type emitter region; one or more insulated gate electrodes lying in gate trenches which extend down into, but not through, said p-type base region; wherein said thyristor cannot sustain conduction unless sufficient positive voltage is applied to said gate electrode.

According to another example not claimed but useful for understanding the invention, there is provided: A semiconductor active device with bipolar conduction, comprising: a first semiconductor region which contains an excess of first-type charge carriers; and a second semiconductor region which contains an excess of second-type charge carriers; a first pn-junction to said first region, and a second pn-junction to said second region; said first and second pn-junctions having the same orientation; a third pn-junction, which separates said first and second pn-junctions, and has an orientation opposite to that of said first and second pn-junctions; a third semiconductor region which is switchably connected to said first location, which is closer than said first region to said third pn-junction, and which, when connected to said first location, provides an excess of first-type charge carriers; wherein, when the third region is not connected to the first region, the combination of said first, second, and third junctions will not latch to sustain conduction across said third junction; and when the third region is connected to the first region, the combination of said first, second, and third junctions will latch to sustain conduction across said third junction under at least some circumstances.

According to another example not claimed but useful for understanding the invention, there is provided: An insulated gate type three terminal thyristor comprising: a first semiconductor emitter region of a first conductivity type having a first impurity concentration; a first semiconductor base region of a second conductivity type opposite to the first conductivity type having a second impurity concentration and formed on said first current terminal semiconductor region; a second semiconductor base region of the first conductivity type having a third impurity concentration lower than the first impurity concentration and formed on said first semiconductor base region; a second semiconductor emitter region of the second conductivity type having a fourth impurity concentration higher than the second impurity concentration and formed on said second semiconductor base region; a trench structure passing through said first semiconductor emitter region and entering said first semiconductor base region without reaching the second semiconductor base region; and an insulated gate electrode structure formed in said trench structure, wherein said trench structure divides an upper portion of said first base semiconductor region into a plurality of regions, and is formed generally around part, but not all of, each divided region.

According to another example not claimed but useful for understanding the invention, there is provided: A solid-state switching method, comprising, in a structure which has a first emitter region over a first base region over a second base region over a second emitter region, with a trench extending into part but not all of the thickness of the first base region, and a gate electrode in the trench: when conduction is desired, connecting the gate electrode to a first voltage which is sufficient to invert adjacent portions of said first base region, and thereby create a population of first-conductivity-type mobile charge carriers at the bottoms of the trenches; and when conduction is not desired, then connecting the gate electrode to a second voltage which neither inverts nor depletes through portions of said first base region between the trenches; wherein net round-trip carrier multiplication occurs between said population and the second emitter region when the gate is connected to the first voltage, and does not occur when the gate is connected to the second voltage.

According to another example not claimed but useful for understanding the invention, there is provided: A method of operating a thyristor device, comprising: when conduction is desired, turning on a field effect transistor to reduce the base width of one bipolar transistor component of the thyristor; and when blocking is desired, turning off said field effect transistor, without pinching off conduction through the base region of said bipolar transistor.

According to another example not claimed but useful for understanding the invention, there is provided: A method of operating a high-power semiconductor device having at least three successively opposed junctions in series, comprising: when conduction is desired, turning on a field effect transistor to reduce the effective spacing between two of said junctions; and when blocking is desired, turning off said field effect transistor, without pinching off conduction through mesa portions of the device.

According to other examples not claimed but useful for understanding the invention, there is provided: Methods and systems for a gate-controlled thyristor which switches between narrow-base operation in the ON state and wide-base operation in the OFF state, and which can only sustain latch-up in the narrow-base ON state.

## Modifications and Variations

In one contemplated, non claimed possibility, transistor base width change can be performed at the anode rather than the cathode by changing the NMOS gate on the cathode face of the die to a PMOS gate on the anode face of the die.

In a further contemplated, non claimed possibility, one can also perform base width change on both faces of the die, by using two-sided processing. Note that the NMOS gate and PMOS gate would not have to be precisely aligned, as long as the active gated areas on the two faces were aligned. In fact, in one contemplated implementation, the gate trenches for the NMOS and PMOS can be arranged orthogonally.

In another contemplated, non claimed possibility, an alternative technique for beta control which can be used in combination with the wide-base/narrow-base change is emitter-base shorting. If the NPN's base voltage is tied to its emitter voltage (as described earlier), the NPN's emitter junction is bypassed, and can never be forward biased. This guarantees that the beta will be less than one, and possibly close to zero. However, this technique requires additional device structure.

In a further contemplated, non claimed possibility, one can reduce carrier lifetimes through electron irradiation only at selected distances from the top of the device. In a non claimed example in which such selective-level lifetime-reduction is desired, the regions between the base-emitter junctions might frequently be the desired target areas.

## Claims

1. A gate-controlled thyristor, comprising:

    an n-type emitter region (129), overlying a p-type base region (107), which itself overlies an n-type base region (106), which in turn overlies a p-type emitter region (104), wherein a doping level of the p-type emitter region (104) is greater than a doping level of the p-type base region (107), wherein the n-type emitter region (129), the p-type base region (107), and the n-type base region (106) form an NPN transistor, and wherein the p-type emitter region (104), the n-type base region (106), and the p-type base region (107) form a PNP transistor;
    an anode terminal (102) connected to the p-type emitter region (104) and a cathode terminal (101) connected to the n-type emitter region (129);
    insulated gate electrodes (143) lying in gate trenches (141) which extend through the n-type emitter region (129) and down into, but not through, said p-type base region (107);
    wherein the NPN transistor current gain defined by the combination of said n-type emitter region (129) with said p-type base region (107) and said n-type base region (106), multiplied by the PNP transistor current gain defined by the combination of said p-type emitter region (104) with said n-type base region (106) and said p-type base region (107), is less than one when a voltage less than a threshold voltage is applied to said insulated gate electrodes (143);
    wherein, when said insulated gate electrodes (143) have been driven sufficiently positive, with respect to a potential of the p-type base region (107), to invert portions of said p-type base region (107) at the sidewalls and the bottom of said gate trenches (141), the NPN transistor current gain defined by the combination of an induced population of electrons at the bottom of said trenches (141) with said p-type base region (107) and said n-type base region (106), multiplied by the PNP transistor current gain defined by the combination of said p-type emitter region (104) with said n-type base region (106) and said p-type base region (107), is greater than one; whereby, when a voltage applied to said gate electrodes (143) is sufficiently positive to invert said p-base region (107), current will flow from the anode terminal (102) to the cathode terminal (101) under forward bias; and when a voltage applied to said insulated gate electrodes (143) is at the same voltage potential as the p-type base region (107), the gate electrodes (143) are not driven sufficiently positive to invert said p-base region (107), and current from said anode terminal (102) to said cathode terminal (101) will be interrupted.

2. The thyristor of Claim 1, wherein said insulated gate electrodes (143) are made of doped polysilicon.

3. The thyristor of any of Claims 1 or 2, wherein one of said p-type base and n-type base regions (106, 107) is an epitaxial layer, and the other of said p-type base and n-type base regions (106, 107) is a well region formed within said epitaxial layer.

4. The thyristor of any of Claims 1-3, wherein the top of said insulated gate electrodes (143) is below the top of said trenches (141).

5. The thyristor of any of Claims 1-4, wherein:

each said base region (106, 107) is made of silicon, and
said insulated gate electrodes (143) are insulated therefrom by a layer of silicon dioxide.

6. The thyristor of any of claims 1-5, wherein said insulated gate electrodes (143) extend down through more than 10%, but less than 90%, of the depth of said p-type base region (107).

7. The thyristor of any of claims 1-6, wherein said thyristor is configured such that conduction cannot be sustained unless sufficient positive voltage, with respect to a potential applied to the p-type base region (107), is applied to said insulated gate electrodes (143).

8. A solid-state switching method, comprising, in a structure which has an n-type emitter region (129) over a p-type base region (107) over an n-type base region (106) over a p-type emitter region (104), wherein a doping level of the p-type emitter region (104) is greater than a doping level of the p-type base region (107), wherein the n-type emitter region (129), the p-type base region (107), and the n-type base region (106) form an NPN transistor, and wherein the p-type emitter region (104), the n-type base region (106), and the p-type base region (107) form a PNP transistor, an anode terminal (102) connected to the p-type emitter region (104) and a cathode terminal (101) connected to the n-type emitter region (129), insulated gate electrodes (143) lying in gate trenches (141) extending through the n-type emitter region (129) and down into, but not through, said p-type base region (107):

when conduction is desired, connecting the gate electrodes (143) to a first voltage which creates a sufficient potential difference between the gate electrodes (143) and the p-type base region (107) to invert adjacent portions of said p-type base region (107), and thereby create a population of n-type mobile charge carriers at the bottoms of the trenches (141); and
when conduction is not desired, then connecting the gate electrodes (143) to a second voltage which neither inverts nor depletes through portions of said p-type base region (107) between the trenches (141);
wherein net round-trip carrier multiplication occurs between said population and the p-type emitter region (104) when the gate electrodes (143) are connected to the first voltage, and does not occur when the gate electrodes (143) are connected to the second voltage;
wherein the NPN transistor current gain defined by the combination of said n-type emitter region (129) with said p-type base region (107) and said n-type base region (106), multiplied by the PNP transistor current gain defined by the combination of said p-type emitter region (104) with said n-type base region (106) and said p-type base region (107), is less than one when a voltage less than a threshold voltage is applied to said insulated gate electrodes (143);
wherein, when said gate electrodes (143) have been driven sufficiently positive, with respect to a potential of the p-type base region (107), to invert portions of said p-type base region (107) at the sidewalls and the bottom of said trenches (141), the NPN transistor current gain defined by the combination of an induced population of electrons at the bottom of said trenches (141) with said p-type semiconductor base region (107) and said n-type semiconductor base region (106), multiplied by the PNP transistor current gain defined by the combination of said p-type emitter region (104) with said n-type base region (106) and said p-type base region (107), is greater than one;
whereby, when a voltage applied to said gate electrodes (143) is sufficiently positive to invert said p-type base region (107), current will flow between said n-type emitter region (129) and said p-type emitter region (104) if forward bias is present; and when a voltage applied to said gate electrodes (143) is at the same voltage potential as the p-type base region (107), the gate electrodes (143) are not driven sufficiently positive to invert said p-type base region (107), and said current will stop.

9. The method of Claim 8, wherein said gate electrodes (143) are made of doped polysilicon.

10. The method of Claim 8 or 9, wherein each said p-type base and n-type base region (106, 107) is made of silicon.

11. The method of any of Claims 8-10, wherein one of said p-type base and n-type base regions (106, 107) is an epitaxial layer, and the other of said p-type base and n-type base regions (106, 107) is a well region formed within said epitaxial layer.

12. The method of any of Claims 8-11, wherein the top of said gate electrodes (143) is below the top of said trenches (141).

13. The method of any of Claims 8-12, wherein the bottom of said trenches (141) is more than 1.5 microns above the junction between said p-type base and n-type base regions (106, 107).

14. The method of any of Claims 8-13, wherein said trenches (141) extend down through more than 40%, but less than 80%, of the depth of said respective p-type base region (107).


**Patentansprüche**

1. Ein Gate-gesteuerter Thyristor, der Folgendes umfasst:

einen n-Typ-Emitterbereich (129), der über einem p-Typ-Basisbereich (107) liegt, der seinerseits über einem n-Typ-Basisbereich (106) liegt, der wiederum über einem p-Typ-Emitterbereich (104) liegt, wobei ein Dotierungsgrad des p-Typ-Emitterbereichs (104) größer ist als ein Dotierungsgrad des p-Typ-Basisbereichs (107), wobei der n-Typ-Emitterbereich (129), der p-Typ-Basisbereich (107) und der n-Typ-Basisbereich (106) einen NPN-Transistor bilden, und wobei der p-Typ-Emitterbereich (104), der n-Typ-Basisbereich (106) und der p-Typ-Basisbereich (107) einen PNP-Transistor bilden;
einen Anodenanschluss (102), der mit dem p-Typ-Emitterbereich (104) verbunden ist, und einen Kathodenanschluss (101), der mit dem n-Typ-Emitterbereich (129) verbunden ist;
isolierte Gate-Elektroden (143), die in Gate-Gräben (141) liegen, die sich durch den n-Typ-Emitterbereich (129) und nach unten in den genannten p-Typ-Basisbereich (107), aber nicht durch diesen hindurch, erstrecken;
wobei die NPN-Transistor-Stromverstärkung, die durch die Kombination des genannten n-Typ-Emitterbereichs (129) mit dem genannten p-Typ-Basisbereich (107) und dem genannten n-Typ-Basisbereich (106) definiert ist, multipliziert mit der PNP-Transistor-Stromverstärkung, die durch die Kombination des genannten p-Typ-Emitterbereichs (104) mit dem genannten n-Typ-Basisbereich (106) und dem genannten p-Typ-Basisbereich (107) definiert ist, kleiner als eins ist, wenn eine Spannung, die kleiner als eine Schwellenspannung ist, an die genannten isolierten Gate-Elektroden (143) angelegt wird;
wobei, wenn die genannten isolierten Gate-Elektroden (143) in Bezug auf ein Potential des p-Typ-Basisbereichs (107), ausreichend positiv angesteuert worden sind, um Abschnitte des genannten p-Typ-Basisbereichs (107) an den Seitenwänden und dem Boden der genannten Gate-Gräben (141) zu invertieren, die NPN-Transistor-Stromverstärkung, die durch die Kombination einer induzierten Population von Elektronen am Boden der genannten Gräben (141) mit dem genannten p-Typ-Basisbereich (107) und dem genannten n-Typ-Basisbereich (106) definiert ist, multipliziert mit der PNP-Transistor-Stromverstärkung, die durch die Kombination des genannten p-Typ-Emitterbereichs (104) mit dem genannten n-Typ-Basisbereich (106) und dem genannten p-Typ-Basisbereich (107) definiert ist, größer als eins ist;
wodurch, wenn eine an die genannten Gate-Elektroden (143) angelegte Spannung ausreichend positiv ist, um den genannten p-Basisbereich (107) zu invertieren, ein Strom vom Anodenanschluss (102) zum Kathodenanschluss (101) unter Vorwärtsvorspannung fließen wird, und wenn eine an die genannten isolierten Gate-Elektroden (143) angelegte Spannung auf dem gleichen Spannungspotential liegt wie der p-Basisbereich (107), die Gate-Elektroden (143) nicht ausreichend positiv angesteuert werden, um den genannten p-Basisbereich (107) zu invertieren, und der Strom vom genannten Anodenanschluss (102) zum genannten Kathodenanschluss (101) unterbrochen werden wird.

2. Der Thyristor nach Anspruch 1, wobei die genannten isolierten Gate-Elektroden (143) aus dotiertem Polysilizium hergestellt sind.

3. Der Thyristor nach irgendeinem der Ansprüche 1 oder 2, wobei einer von dem genannten p-Typ-Basisbereich und dem genannten n-Typ-Basisbereich (106, 107) eine Epitaxialschicht ist, und der andere von dem genannten p-Typ-Basisbereich und dem genannten n-Typ-Basisbereich (106, 107) ein innerhalb der Epitaxialschicht gebildeter Wannenbereich (*well region*) ist.

4. Der Thyristor nach irgendeinem der Ansprüche von 1 bis 3, wobei die Oberseite der genannten isolierten Gate-Elektroden (143) unterhalb der Oberseite der genannten Gräben (141) liegt.

5. Der Thyristor nach irgendeinem der Ansprüche von 1 bis 4, wobei:

   jeder der genannten Basisbereiche (106, 107) aus Silizium besteht, und wobei
   die genannten isolierten Gate-Elektroden (143) durch eine Schicht aus Siliziumdioxid davon isoliert sind.

6. Der Thyristor nach irgendeinem der Ansprüche von 1 bis 5, wobei sich die genannten isolierten Gate-Elektroden (143) nach unten erstrecken durch mehr als 10%, aber weniger als 90% der Tiefe des genannten p-Typ-Basisbereichs (107).

7. Der Thyristor nach irgendeinem der Ansprüche von 1 bis 6, wobei der genannte Thyristor so konfiguriert ist, dass die Leitung nicht aufrechterhalten werden kann, wenn nicht eine ausreichende positive Spannung in Bezug auf ein an den p-Basisbereich (107) angelegtes Potential an die genannten isolierten Gate-Elektroden (143) angelegt wird.

8. Ein Halbleiter-Schaltverfahren, umfassend, in einer Struktur, die Folgendes aufweist: einen n-Typ-Emitterbereich (129) über einem p-Typ-Basisbereich (107) über einem n-Typ-Basisbereich (106) über einem p-Typ-Emitterbereich (104), wobei ein Dotierungsgrad des p-Typ-Emitterbereichs (104) größer ist als ein Dotierungsgrad des p-Typ-Basisbereichs (107), wobei der n-Typ-Emitterbereich (129), der p-Typ-Basisbereich (107) und der n-Typ-Basisbereich (106) einen NPN-Transistor bilden, und wobei der p-Typ-Emitterbereich (104), der n-Typ-Basisbereich (106) und der p-Typ-Basisbereich (107) einen PNP-Transistor bilden, einen Anodenanschluss (102), der mit dem p-Typ-Emitterbereich (104) verbunden ist, und einen Kathodenanschluss (101), der mit dem n-Typ-Emitterbereich (129) verbunden ist, isolierte Gate-Elektroden (143) in Gate-Gräben (141) liegen, die sich durch den n-Typ-Emitterbereich (129) und nach unten in den genannten p-Typ-Basisbereich (107), aber nicht durch diesen hindurch erstrecken:

   wenn Leitung erwünscht ist, Verbinden der Gate-Elektroden (143) mit einer ersten Spannung, die eine ausreichende Potentialdifferenz zwischen den Gate-Elektroden (143) und dem p-Typ-Basisbereich (107) erzeugt, um benachbarte Abschnitte des genannten p-Typ-Basisbereichs (107) zu invertieren und dadurch eine Population von mobilen n-Typ-Ladungsträgern an den Böden der Gräben (141) zu erzeugen; und wenn eine Leitung nicht erwünscht ist, dann Verbinden der Gate-Elektroden (143) mit einer zweiten Spannung, die durch Abschnitte des genannten p-Typ-Basisbereichs (107) zwischen den Gräben (141) weder invertiert noch sperrt (*depletes*);
wobei eine Netto-*Roundtrip*-Trägervervielfachung zwischen der genannten Population und dem p-Typ-Emitterbereich (104) auftritt, wenn die Gate-Elektroden (143) mit der ersten Spannung verbunden sind, und nicht auftritt, wenn die Gate-Elektroden (143) mit der zweiten Spannung verbunden sind;
wobei die NPN-Transistor-Stromverstärkung, die durch die Kombination des genannten n-Typ-Emitterbereichs (129) mit dem genannten p-Typ-Basisbereich (107) und dem genannten n-Typ-Basisbereich (106) definiert ist, multipliziert mit der PNP-Transistor-Stromverstärkung, die durch die Kombination des genannten p-Typ-Emitterbereichs (104) mit dem genannten n-Typ-Basisbereich (106) und dem genannten p-Typ-Basisbereich (107) definiert ist, kleiner als eins ist, wenn eine Spannung, die kleiner als eine Schwellenspannung ist, an die genannten isolierten Gate-Elektroden (143) angelegt wird;
wobei, wenn die genannten Gate-Elektroden (143) in Bezug auf ein Potential des p-Typ-Basisbereichs (107), ausreichend positiv angesteuert worden sind, um Abschnitte des genannten p-Typ-Basisbereichs (107) an den Seitenwänden und dem Boden der genannten Gräben (141) zu invertieren, die NPN-Transistor-Stromverstärkung, die durch die Kombination einer induzierten Population von Elektronen am Boden der genannten Gräben (141) mit dem genannten p-Typ-Halbleiter-Basisbereich (107) und dem genannten n-Typ-Halbleiter-Basisbereich (106) definiert ist, multipliziert mit der PNP-Transistor-Stromverstärkung, die durch die Kombination des genannten p-Typ-Emitterbereichs (104) mit dem genannten n-Typ-Basisbereich (106) und dem genannten p-Typ-Basisbereich (107) definiert ist, größer als eins ist;
wodurch, wenn eine an die genannten Gate-Elektroden (143) angelegte Spannung ausreichend positiv ist, um den genannten p-Typ-Basisbereich (107) zu invertieren, ein Strom zwischen dem genannten n-Typ-Emitterbereich (129) und dem genannten p-Typ-Emitterbereich (104) fließen wird falls eine Vorwärtsvorspannung vorhanden ist; und wenn eine an die genannten Gate-Elektroden (143) angelegte Spannung auf dem gleichen Spannungspotential liegt wie der p-Typ-Basisbereich (107), die Gate-Elektroden (143) nicht ausreichend positiv angesteuert werden, um den genannten p-Typ-Basisbereich (107) zu invertieren, und der genannten Strom stoppen wird.

9. Das Verfahren nach Anspruch 8, wobei die genannten Gate-Elektroden (143) aus dotiertem Polysilizium hergestellt sind.

10. Das Verfahren nach Anspruch 8 oder 9, wobei jeder der genannten p-Typ-Basis- und n-Typ-Basisbereiche (106, 107) aus Silizium hergestellt ist.

11. Das Verfahren nach irgendeinem der Ansprüche von 8 bis 10, wobei einer von dem genannten p-Typ-Basisbereich und dem genannten n-Typ-Basisbereich (106, 107) eine Epitaxialschicht ist und der andere von dem genannten p-Typ-Basisbereich und dem n-Typ-Basisbereich (106, 107) ein innerhalb der genannten Epitaxialschicht gebildeter Wannenbereich ist.

12. Das Verfahren nach irgendeinem der Ansprüche von 8 bis 11, wobei die Oberseite der genannten Gate-Elektroden (143) unterhalb der Oberseite der genannten Gräben (141) liegt.

13. Das Verfahren nach irgendeinem der Ansprüche von 8 bis 12, wobei der Boden der genannten Gräben (141) mehr als 1,5 Mikrometer über dem Übergang zwischen den genannten p-Typ-Basisbereich und n-Typ-Basisbereich (106, 107) liegt.

14. Das Verfahren nach irgendeinem der Ansprüche von 8 bis 13, wobei sich die genannten Gräben (141) über mehr als 40%, aber weniger als 80% der Tiefe des genannten jeweiligen p-Typ-Basisbereichs (107) nach unten erstrecken.

**Revendications**

1. Un thyristor commandé par grille, comprenant :

une région d'émetteur de type n (129), recouvrant une région de base de type p (107), qui elle-même recouvre une région de base de type n (106), qui à son tour recouvre une région d'émetteur de type p (104), sachant que le niveau de dopage de la région d'émetteur de type p (104) est supérieur au niveau de dopage de la région de base de type p (107), sachant que la région d'émetteur de type n (129), la région de base de type p (107) et la région de base de type n (106) forment un transistor NPN, et sachant que la région d'émetteur de type p (104), la région de base de type n (106) et la région de base de type p (107) forment un transistor PNP ;
une borne d'anode (102) connectée à la région d'émetteur de type p (104) et une borne de cathode (101) connectée à la région d'émetteur de type n (129) ;
des électrodes de grille isolée (143) se trouvant dans des tranchées de grille (141) qui s'étendent à travers la région d'émetteur de type n (129) et vers le bas dans, mais pas à travers, ladite région de base de type p (107) ;
sachant que le gain en courant du transistor NPN défini par la combinaison de ladite région d'émetteur de type n (129) avec ladite région de base de type p (107) et ladite région de base de type n (106), multiplié par le gain en courant du transistor PNP défini par la combinaison de ladite région d'émetteur de type p (104) avec ladite région de base de type n (106) et ladite région de base de type p (107), est inférieur à un lorsqu'une tension inférieure à une tension de seuil est appliquée auxdites électrodes de grille isolée (143) ;
sachant que, lorsque lesdites électrodes de grille isolée (143) ont été commandées (*driven*) de manière suffisamment positive par rapport à un potentiel de la région de base de type p (107), pour inverser des portions de ladite région de base de type p (107) au niveau des parois latérales et du fond desdites tranchées de grille (141), le gain en courant du transistor NPN défini par la combinaison d'une population induite d'électrons au fond desdites tranchées (141) avec ladite région de base de type p (107) et ladite région de base de type n (106), multiplié par le gain en courant du transistor PNP défini par la combinaison de ladite région d'émetteur de type p (104) avec ladite région de base de type n (106) et ladite région de base de type p (107), est supérieur à un ;
d'où il résulte que, lorsqu'une tension appliquée auxdites électrodes de grille (143) est suffisamment positive pour inverser ladite région de base de type p (107), le courant passera depuis la borne d'anode (102) jusqu'à la borne de cathode (101) sous polarisation directe (*under forward bias*) ; et que lorsqu'une tension appliquée auxdites électrodes de grille isolée (143) est au même potentiel de tension que la région de base de type p (107), les électrodes de grille (143) ne sont pas commandées suffisamment positivement pour inverser ladite région de base p (107), et le courant depuis ladite borne d'anode (102) jusqu'à ladite borne de cathode (101) sera interrompu.

2. Le thyristor d'après la revendication 1, sachant que lesdites électrodes de grille isolée (143) sont constituées de polysilicium dopé.

3. Le thyristor d'après l'une quelconque des revendications 1 ou 2, sachant que l'une parmi ladite région de base de type p et ladite région de base de type n (106, 107) est une couche épitaxiale, et que l'autre parmi ladite région de base de type p et ladite région de base de type n (106, 107) est une région de puit formée dans ladite couche épitaxiale.

4. Le thyristor d'après l'une quelconque des revendications de 1 à 3, sachant que le sommet desdites électrodes de grille isolée (143) se trouve en dessous du sommet desdites tranchées (141).

5. Le thyristor d'après l'une quelconque des revendications de 1 à 4, sachant que :

   chacune desdites régions de base (106, 107) est constituée de silicium, et que lesdites électrodes de grille isolée (143) sont isolées de celles-ci par une couche de dioxyde de silicium.

6. Le thyristor d'après l'une quelconque des revendications de 1 à 5, sachant que lesdites électrodes de grille isolée (143) s'étendent vers le bas sur plus de 10 %, mais moins de 90 %, de la profondeur de ladite région de base de type p (107).

7. Le thyristor d'après l'une quelconque des revendications de 1 à 6, sachant que ledit thyristor est configuré de manière que la conduction ne peut être maintenue que si une tension positive suffisante, par rapport à un potentiel appliqué à la région de base de type p (107), est appliquée auxdites électrodes de grille isolée (143).

8. Un procédé de commutation à semi-conducteur, comprenant, dans une structure qui présente une région d'émetteur de type n (129) au-dessus d'une région de base de type p (107) au-dessus d'une région de base de type n (106) au-dessus d'une région d'émetteur de type p (104), sachant que le niveau de dopage de la région d'émetteur de type p (104) est supérieur au niveau de dopage de la région de base de type p (107), sachant que la région d'émetteur de type n (129), la région de base de type p (107) et la région de base de type n (106) forment un transistor NPN, et sachant que la région d'émetteur de type p (104), la région de base de type n (106) et la région de base de type p (107) forment un transistor PNP, une borne d'anode (102) connectée à la région d'émetteur de type p (104) et une borne de cathode (101) connectée à la région d'émetteur de type n (129), des électrodes de grille isolée (143) se trouvant dans des tranchées de grille (141) s'étendant à travers la région d'émetteur de type n (129) et descendant dans, mais pas à travers, ladite région de base de type p (107) :

lorsque la conduction est souhaitée, le fait de connecter les électrodes de grille (143) à une première tension qui crée une différence de potentiel suffisante entre les électrodes de grille (143) et la région de base de type p (107) pour inverser des portions adjacentes de ladite région de base de type p (107), et de créer ainsi une population de porteurs de charge mobiles de type n au fond des tranchées (141) ; et lorsque la conduction n'est pas souhaitée, le fait de connecter les électrodes de grille (143) à une deuxième tension qui ne s'inverse ni s'épuise à travers des parties de ladite région de base de type p (107) entre les tranchées (141) ;
sachant que la multiplication nette aller-retour de porteurs de charge (*net round-trip carrier multiplication*) se produit entre ladite population et la région d'émetteur de type p (104) lorsque les électrodes de grille (143) sont connectées à la première tension, et ne se produit pas lorsque les électrodes de grille (143) sont connectées à la deuxième tension ;
sachant que le gain en courant du transistor NPN défini par la combinaison de ladite région d'émetteur de type n (129) avec ladite région de base de type p (107) et ladite région de base de type n (106), multiplié par le gain en courant du transistor PNP défini par la combinaison de ladite région d'émetteur de type p (104) avec ladite région de base de type n (106) et ladite région de base de type p (107), est inférieur à un lorsqu'une tension inférieure à une tension de seuil est appliquée auxdites électrodes de grille isolée (143) ;
sachant que, lorsque lesdites électrodes de grille (143) ont été commandées de manière suffisamment positive, par rapport à un potentiel de la région de base de type p (107), pour inverser des portions de ladite région de base de type p (107) au niveau des parois latérales et du fond desdites tranchées (141), le gain en courant du transistor NPN défini par la combinaison d'une population induite d'électrons au fond desdites tranchées (141) avec ladite région de base semi-conductrice de type p (107) et ladite région de base semi-conductrice de type n (106), multiplié par le gain en courant du transistor PNP défini par la combinaison de ladite région d'émetteur de type p (104) avec ladite région de base de type n (106) et ladite région de base de type p (107), est supérieur à un ;
d'où il résulte que, lorsqu'une tension appliquée auxdites électrodes de grille (143) est suffisamment positive pour inverser ladite région de base de type p (107), le courant passera entre ladite région d'émetteur de type n (129) et ladite région d'émetteur de type p (104) si une polarisation directe est présente ; et que lorsqu'une tension appliquée auxdites électrodes de grille (143) est au même potentiel de tension que la région de base de type p (107), les électrodes de grille (143) ne sont pas commandées suffisamment positivement pour inverser ladite région de base de type p (107), et ledit courant s'arrêtera.

9. Le procédé d'après la revendication 8, sachant que lesdites électrodes de grille (143) sont constituées de polysilicium dopé.

10. Le procédé d'après la revendication 8 ou 9, sachant que chaque dite région de base de type p et dite région de base de type n (106, 107) est constituée de silicium.

11. Le procédé d'après l'une quelconque des revendications de 8 à 10, sachant que l'une parmi ladite région de base de type p et ladite région base de type n (106, 107) est une couche épitaxiale, et que l'autre parmi ladite région de base de type p et ladite région base de type n (106, 107) est une région de puit formée dans ladite couche épitaxiale.

12. Le procédé d'après l'une quelconque des revendications de 8 à 11, sachant que le sommet desdites électrodes de grille (143) se trouve en dessous du sommet desdites tranchées (141).

13. Le procédé d'après l'une quelconque des revendications de 8 à 12, sachant que le fond desdites tranchées (141) se trouve à plus de 1,5 micron au-dessus de la jonction entre lesdites régions de base de type p et de base de type n (106, 107).

14. Le procédé d'après l'une quelconque des revendications de 8 à 13, sachant que lesdites tranchées (141) s'étendent vers le bas sur plus de 40 %, mais moins de 80 %, de la profondeur de ladite région de base de type p (107) respective.

**FIG. 1**

**FIG. 1A**

**FIG. 1B**

**FIG. 2**

**FIG. 3A**

**FIG. 3B**

P-type
Dopant

N-type
Dopant

Cross
section

**FIG. 4A**

Gate direction    Polysilicon    429    441

n+    n+

p    407

**FIG. 4B**

**FIG. 5A**

**FIG. 5B**

**FIG. 5C**

Contact opening

Wide trench for contacting tgate
polysilicon in the trench

↑ Perimeter of Device
↓ Active Area of Device

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7705368 B2
- EP 0480356 A2
- EP 0854518 A1

**Non-patent literature cited in the description**

- **B. JAYANT BALIGA.** Power Semiconductor Devices. PWS Publishing Company, 1996